# EUROPEAN PATENT APPLICATION

(11) **EP 4 845 311 A1**
(43) Date of publication of application: **25.11.2026**
(21) Application number: 26157937.9
(22) Date of filing: 11.02.2026
(51) Int. Cl.: H05K 1/02, H01M 50/583, H05K 1/189

(54) **CONTROL UNIT AND BATTERY PACK INCLUDING THE SAME**

(30) Priority: 21.05.2025 KR 20250066014
(71) Applicant: SAMSUNG SDI CO., LTD., Yongin-si, Gyeonggi-do 17084 (KR)
(72) Inventor: PARK, KYUNGHOON, 17084 YONGIN-SI (KR)
(74) Representative: Regimbeau

(57) **Abstract**

A control unit, including a body portion (11), a plurality of relays (12) accommodated in the body portion, and a blocking element (15) electrically connected to at least one relay from among the plurality of relays, the blocking element blocking a flow of an overcurrent, wherein the blocking element includes a flexible printed circuit board.

## Description

### FIELD

The disclosure relates to a control unit and a battery pack including the same.

### TECHNICAL BACKGROUND

Secondary batteries refer to batteries that may be charged and discharged, unlike primary batteries that may not be recharged. Low-capacity battery cells are used in small, portable electronic devices such as smartphones, feature phones, laptop computers, digital cameras, and camcorders, and large-capacity battery cells are widely used as power sources, power storage batteries, and the like for driving motors in hybrid vehicles, electric vehicles, and the like. Battery cells described above include electrode assemblies including positive electrodes and negative electrodes, cases accommodating the electrode assemblies, electrode terminals connected to the electrode assemblies, and the like.

The above-described information provided in the related art of the disclosure is only intended to improve understanding of the background of the disclosure and therefore may include information that does not constitute the related art.

### SUMMARY

Embodiments include a control unit, including a body portion, a plurality of relays accommodated in the body portion, and a blocking element electrically connected to at least one relay from among the plurality of relays, the blocking element blocking a flow of an overcurrent, wherein the blocking element includes a flexible printed circuit board.

The flexible printed circuit board may include a plurality of circuit elements connected to one another in parallel, and the plurality of circuit elements may be fractured when a temperature increases due to the overcurrent.

Each of the plurality of circuit elements may include a conductive layer, insulating layers above opposite side surfaces of the conductive layer, and adhesive layers between the conductive layer and the insulating layers.

When the temperature increases, the plurality of circuit elements may be fractured starting from a circuit element of the plurality of circuit elements at a central portion.

The plurality of circuit elements may be stacked in a height direction of the control unit.

The plurality of circuit elements may be stacked in 14 layers to 38 layers in the height direction of the control unit.

The conductive layer may include a copper thin film.

The conductive layer may have a thickness of 0.025 mm to 0.05 mm.

The plurality of relays may include a first relay and a second relay, the first relay may be on a current path electrically connected to a first electrode, and the second relay may be on a current path electrically connected to a second electrode.

The first relay may be on a current path electrically connected to a positive electrode, and the blocking element may be electrically connected to the first relay.

The control unit may further include a battery management system, wherein, when power is applied from the battery management system, the plurality of relays may be controlled from an off state to an on state.

Embodiments include a battery pack, including a housing accommodating at least one battery, and a battery management system configured to manage the at least one battery, wherein the battery management system includes a control unit, the control unit including a body portion, a plurality of relays accommodated in the body portion, and a blocking element electrically connected to at least one relay from among the plurality of relays, the blocking element blocking a flow of an overcurrent, wherein the blocking element includes a flexible printed circuit board.

The flexible printed circuit board may include a plurality of circuit elements connected to one another in parallel, and the plurality of circuit elements may be fractured when a temperature increases due to the overcurrent.

Each of the plurality of circuit elements may include a conductive layer, insulating layers above opposite side surfaces of the conductive layer, and adhesive layers between the conductive layer and the insulating layers.

When the temperature increases, the plurality of circuit elements may be fractured starting from a circuit element of the plurality of circuit elements at a central portion.

The plurality of circuit elements may be stacked in a height direction of the control unit.

The plurality of circuit elements may be stacked in 14 layers to 38 layers in the height direction of the control unit.

The conductive layer may include a copper thin film.

The conductive layer may have a thickness of 0.025 mm to 0.05 mm.

When power is applied from the battery management system, the plurality of relays may be controlled from an off state to an on state.

However, the technical problems to be solved by the disclosure are not limited to the problems described above, and other problems not mentioned may be clearly understood by those skilled in the art from the description described below.

### BRIEF DESCRIPTION OF THE DRAWINGS

The following drawings attached to the description illustrate embodiments and, together with the detailed description below, serve to allow the disclosure to be further understood, and thus, the disclosure should not be interpreted as being limited to matters described in the drawings:

Features will become apparent to those of ordinary skill in the art by describing in detail exemplary embodiments with reference to the attached drawings; in which:
FIG. 1 is an exploded perspective view schematically illustrating an example of a control unit according to an embodiment;
FIG. 2 is a plan view schematically illustrating an example of the control unit of FIG. 1;
FIG. 3 is a cross-sectional view taken along line I-I' of FIG. 2;
FIG. 4 is a view schematically illustrating an example of a blocking element of FIG. 3;
FIG. 5 is an exploded perspective view schematically illustrating an example of a control unit according to another embodiment; and
FIG. 6 is a plan view schematically illustrating an example of the control unit of FIG. 5.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

Hereinafter, embodiments are described in detail with reference to the attached drawings. Prior to describing the same, terms or words used in the description and claims should not be construed as being limited to ordinary or dictionary meanings, and should be construed as meanings and concepts consistent with the disclosure based on the principle that the inventor may appropriately define the concepts of the terms in order to describe the disclosure in the best way. Therefore, embodiments described in the description and components illustrated in the drawings are only some embodiments and do not represent all of the disclosure, and thus, it should be understood that there may be various equivalents and modified examples that may replace them at the time of filing the present application.

In addition, as used herein, "comprise," "include," "comprising," and/or "including" specify the existence of the aforementioned shapes, figures, steps, operations, elements, components, and/or groups, and do not exclude the existence or addition of one or more other shapes, figures, operations, elements, components, and/or groups.

In addition, in order to help understanding of the disclosure, the attached drawings are not shown to actual scale, but dimensions of some components may be exaggerated. Also, the same reference numerals may be assigned to the same components in different embodiments.

Although the terms first, second, etc. are used herein to describe various components, these components are not limited by these terms. These terms are only used to distinguish one component from another component, and unless otherwise specifically stated, and a first component may also be a second component.

Throughout the description, unless otherwise specifically stated, each element may be singular or plural.

Any component being disclosed "above (or below)" a component or "on (or underneath) a component may indicate that any component is not only disposed in contact with an upper surface (or a lower surface) of the component, but also another component may be present between the component and any component disposed on (or underneath) the component.

Also, it should be understood that, when a component is referred to as being "coupled to," "combined with" or "connected to" another component, the components may be directly coupled or connected to each other, but another component may be "present" between the respective components, or the respective components may be "coupled to," "combined with" or "connected to" each other through another component. In addition, when a part is referred to as being electrically coupled to another part, this includes not only the case where the parts are directly coupled to each other, but also the case where the parts are coupled to each other with another element therebetween.

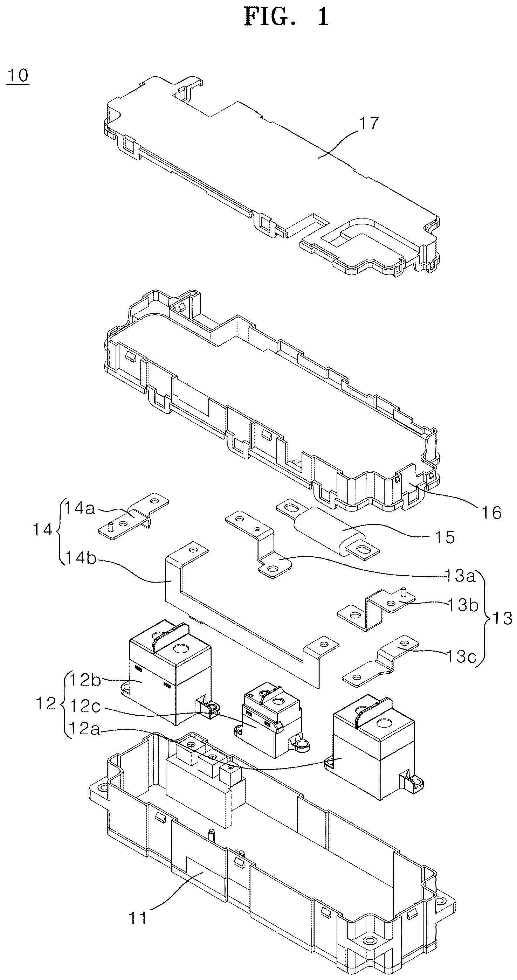

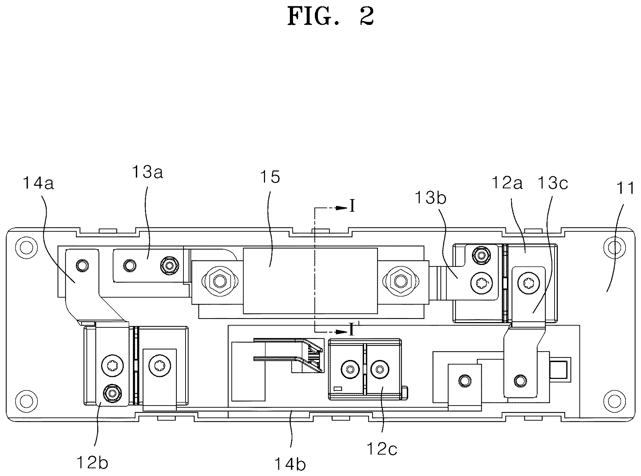

FIG. 1 is an exploded perspective view schematically illustrating an example of a control unit according to an embodiment, and FIG. 2 is a plan view schematically illustrating an example of the control unit of FIG. 1.

Referring to FIGS. 1 and 2, a control unit 10 according to an embodiment may include a body portion 11 in which electronic components may be accommodated, a plurality of relays 12 accommodated in the body portion 11, connection portions 13 and 14 electrically connected to at least one of the plurality of relays 12, and a blocking element 15 arranged between at least one of the connection portions from among the connection portions 13 and 14, and may further include an intermediate cover 16 disposed on the body portion 11 to cover the body portion 11, a top cover 17 arranged to cover the intermediate cover 16, and a wire harness arranged between the top cover 17 and the intermediate cover 16.

The body portion 11 may have a space defined therein to accommodate a plurality of electronic components.

The plurality of relays 12 may be accommodated in the body portion 11 and may be controlled from an off state to an on state when power is applied from the outside.

The plurality of relays 12 may be mechanical contactors that are turned on or off by a magnetic force of a coil, or semiconductor switches such as metal oxide semiconductor field effect transistors (MOSFETs).

In the case where an issue occurs in a vehicle and a battery system, the plurality of relays 12 may include, for example, a first relay 12a, a second relay 12b, and one or more third relays 12c respectively connected to a first electrode terminal and a second electrode terminal, as a function of cutting off a power supply from a battery. For example, the first relay 12a may include a main relay connected to a positive terminal, the second relay 12b may include a main relay connected to a negative terminal, and the third relays 12c may include a precharge relay.

In a selective embodiment, precharge control by the third relay 12c may pose a risk of generating an inrush current in a high voltage capacitor on an inverter input side when a battery load is connected, and thus, to prevent the inrush current from flowing in, a function may be provided to operate the third relay 12c before connecting the first relay 12a and the second relay 12b when the vehicle is started and connect the same to a precharge resistor (not shown).

The connection portions 13 and 14 may include, for example, a busbar, and may include the positive connection portion 13, which is electrically connected to the first relay 12a electrically connected to the positive terminal, to form a current path and the negative connection portion 14, which is electrically connected to the second relay 12b electrically connected to the negative terminal, to form a current path.

The positive connection portion 13 may include, for example, a first positive connection portion 13a and a second positive connection portion 13b that transmit, to the first relay 12a, power applied from an external apparatus, e.g., a battery management system (BMS), and a third positive connection portion 13c that transmits a current, which flows as the first relay 12a is controlled to be turned on by power applied from the BMS, to an external apparatus, e.g., a positive terminal of the battery, and the negative connection portion 14 may include, for example, a first negative connection portion 14a that transmits, to the second relay 12b, power applied from the external apparatus, e.g., the BMS, and a second negative connection portion 14b that transmits a current, which flows as the second relay 12b is controlled to be turned on by power applied from the BMS, to an external apparatus, e.g., a negative terminal of the battery.

The blocking element 15 may be arranged in one area of the positive connection portion 13 and may include a function of a fuse for blocking an overcurrent and a short-circuit current when the overcurrent and the short-circuit current flow by an external power supply apparatus. For example, the blocking element 15 may be arranged between the first positive connection portion 13a and the second positive connection portion 13b and may be fractured when the overcurrent and the short-circuit current are applied from the BMS, to block a flow of current flowing to the first relay 12a. By blocking the overcurrent and the short-circuit current flowing to the first relay 12a as described above, the blocking element 15 may protect electronic components and circuits constituting the control unit 10, and may improve the stability of the battery by preventing the overcurrent and the short-circuit current from being applied to the battery.

In an embodiment, the blocking element 15 may generally have a structure in which a fuse element, which is an internal available portion, is fused when an overcurrent is generated, and an arc-quenching filler, which is a power blocking material, enters between fuse elements when an internal filler is fused, to block power, but an arc-quenching filler case or the like may be high-priced and may take up a large space area. In some embodiments, the arc-quenching filler may include sand, silicon, and the like, and may quench an arc, i.e., eliminate arc discharge.

In some embodiments, to solve the above issue, a method of applying only a fuse element to an overcurrent and a high current to reduce cost may be present, but in the case where only the fuse element is used, a fire may occur in a battery pack due to the occurrence of sparks caused by an arc when an overcurrent and a high current flow.

However, by using a flexible printed circuit board (FPCB) as the blocking element 15, the control unit 10 according to an embodiment may reduce cost and prevent the risk of generating sparks due to the arc.

For example, the FPCB may include a multi-layer FPCB and may be formed so that respective layers may have different patterns, and the respective layers may be electrically connected to one another through via holes formed in the respective layers and thus a plurality of layers may be stacked.

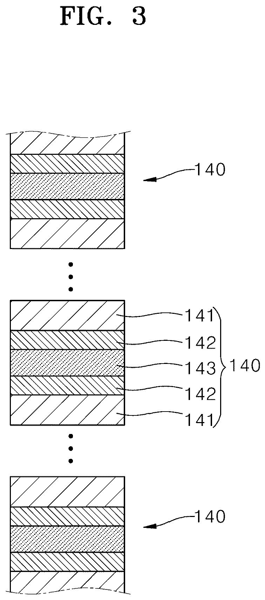

FIG. 3 is a cross-sectional view taken along line I-I' of FIG. 2.

Referring to FIG. 3, the blocking element 15 may include a plurality of circuit elements 140, and each of the circuit elements 140 may include a conductive layer 143, insulating layers 141 located above opposite side surfaces of the conductive layer 143, and adhesive layers 142 between the conductive layer 143 and the insulating layers 141.

The conductive layer 143 may include, for example, a copper thin film, and the conductive layer 143 may have a thickness of 0.025 mm to 0.05 mm.

The insulating layer 141 may include, for example, a polymer material, and may include any material that may be used as an insulating layer. For example, the insulating layer 141 may include thermoplastic plastic, more particularly, may include a polymer material having heat resistance at a temperature of 100 °C to 300 °C, and in some embodiments, may be polyimide (PI). In some embodiments, in case the insulating layer 141 is fused at less than 100 °C, the insulating layer 141 may be easily fractured even by heat generation due to a normal current and thus a current may be cut off, and in the case where the insulating layer 141 is fused at 300 °C or more, the insulating layer 141 may not be fractured quickly in an overcurrent situation and thus may fail to prevent a flow of an overcurrent.

The adhesive layer 142 may be arranged between the conductive layer 143 and the insulating layer 141 to prevent a gap between the conductive layer 143 and the insulating layer 141.

In some embodiments, the blocking element 15 may include, for example, a structure in which the plurality of circuit elements 140 are stacked in a plurality of layers. For example, the circuit elements 140 may be stacked in a plurality of layers as the outermost arranged of the insulating layers 141 are in contact with each other. In some embodiments, the circuit elements 140 forming respective layers may be formed to have different patterns, and the respective circuit elements 140 may include the conductive layers 143 that are connected to each other through via holes located in the insulating layers 141 and the adhesive layers 142, and thus, the circuit elements 140 forming the respective layers may be electrically connected to each other.

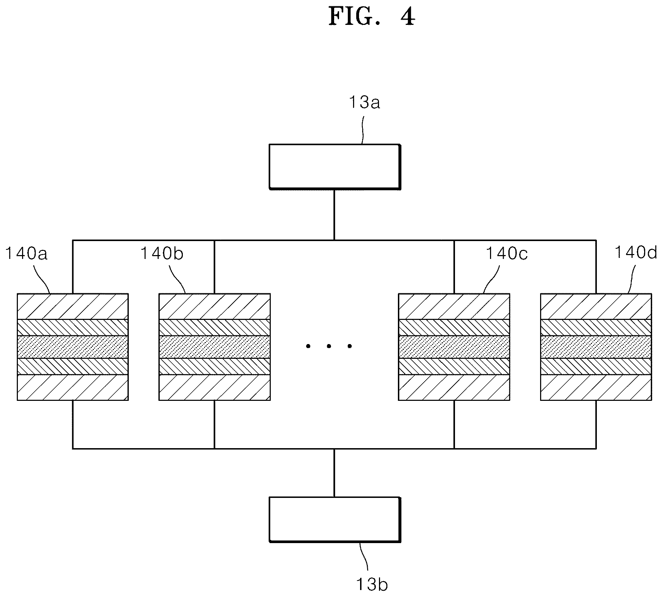

FIG. 4 is a view schematically illustrating an example of a blocking element of FIG. 3.

Referring to FIG. 4, a plurality of circuit elements 140a, 140b, 140c, and 140d may be connected to one another in parallel, e.g., may be connected to a first positive connection portion 13a and a second positive connection portion 13b in parallel between the first positive connection portion 13a and the second positive connection portion 13b.

In a selective embodiment, each of the plurality of circuit elements 140a, 140b, 140c, and 140d may be stacked in a plurality of layers as described as an example in the embodiment of FIG. 3. In some embodiments, the circuit elements 140 stacked in the plurality of layers may be stacked in a height direction of the control unit 10 of FIG. 1, i.e., in a thickness direction of the blocking element 15. In some embodiments, the plurality of circuit elements 140a, 140b, 140c, and 140d stacked as described above may be connected to the first positive connection portion 13a and the second positive connection portion 13b, respectively, between the first positive connection portion 13a and the second positive connection portion 13b and thus may have a parallel structure.

The plurality of circuit elements 140a, 140b, 140c, and 140d may be connected to the first positive connection portion 13a and the second positive connection portion 13b, respectively, between the first positive connection portion 13a and the second positive connection portion 13b to have the parallel structure. Therefore, referring back to FIG. 2, the blocking element 15 may block the flow of current only when all circuit elements constituting the blocking element 15 are fractured, and in contrast, damage to layers of one circuit element or a plurality of circuit elements may not block the flow of current, and thus, the blocking element 15 may perform a function of a busbar even in the case where a defect occurs in layers of any one circuit element or a plurality of circuit elements.

In some embodiments, referring back to FIG. 3, the circuit elements 140 stacked in the plurality of layers may be fractured starting from the circuit element 140 located at the center when a temperature rises due to the flow of the overcurrent. To this end, the conductive layer 143 of the circuit element 140 located at a central portion may be formed greater than (e.g., larger than) the conductive layers 143 of the circuit elements 140 at the other layers to allow a large amount of current to flow from the substantial portion.

In some embodiments, the circuit elements 140 may be stacked in 14 layers to 38 layers, and in this case, the conductive layer 143 may have a thickness of 0.025 mm to 0.05 mm. As described above, the circuit elements 140 may be stacked in 14 layers to 38 layers and the conductive layer 143 may have a thickness of 0.025 mm to 0.05 mm, and thus, all the conductive layers 143 constituting the blocking element 15 may implement an optimal volume. In some embodiments, the conductive layer 143 may have a total volume of 2025 mm³ to 2475 mm³.

In some embodiments, in the case where the circuit elements 140 are stacked in fewer than 14 layers, the blocking element 15 may excessively decrease in the thickness and be fractured by external impact rather than by an overcurrent, and in the case where the circuit elements 140 are stacked in 38 layers or more, the blocking element 15 may excessively increase in the thickness and thus take up a lot of space inside the control unit 10.

In some embodiments, the thickness of the conductive layer 143 may vary according to the number of stacks of the circuit elements 140, in the case where the circuit elements 140 are stacked in 14 layers to 38 layers, the conductive layer 143 may have a thickness of 0.025 mm to 0.05 mm, and in the case where the conductive layer 143 has the thickness of less than 0.025 mm, the total volume of the conductive layer 143 applied to the blocking element 15 may decrease, and thus, a current weaker than a current at a desired level may flow, and in the case where the thickness of the conductive layer 143 exceeds 0.05 mm, the total volume of the conductive layer 143 applied to the blocking element 15 may excessively increase and thus the blocking element 15 may not be fractured by a fusing current.

In some embodiments, in the case where the total volume of the conductive layer 143 is less than 2025 mm³, a normal current, i.e., a weaker current than a current at a desired level, may flow, and in the case where the total volume of the conductive layer 143 exceeds 2475 mm³, the blocking element 15 may not be fractured by the fusing current. In some embodiments, the normal current may be a current of about 200 A, and the fusing current may be a current of about 3200 A flowing for a short period of time.

In an embodiment, a control unit may easily block a high voltage and a high current greater than a normal voltage and a normal current applied in normal times by changing a stack structure of the circuit element 140 according to the capacity of a current being applied. For example, in the case where the capacity of a current being applied in normal times is greater, the total volume of the conductive layer 143 applied to the blocking element 15 may increase by increasing layers of the circuit element 140 being stacked, and in the case where the capacity of the current being applied in normal times is smaller, the total volume of the conductive layer 143 applied to the blocking element 15 may decrease by decreasing layers of the circuit element 140 being stacked. As described above, an action may be easily taken according to the capacity of a current being applied by changing the stack structure of the circuit element 140 according to the capacity of the current being applied and accordingly, a high voltage and a high current applied by an overcurrent may be easily blocked.

As a result, by replacing a fuse with a FPCB, a control unit according to an embodiment may reduce the cost by replacing a high-priced fuse material and may stably block an overcurrent when the overcurrent flows.

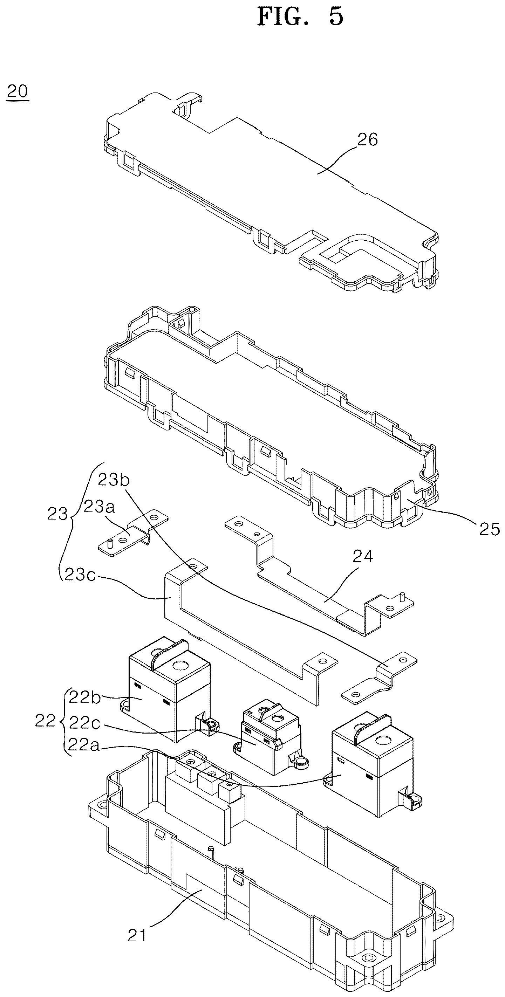

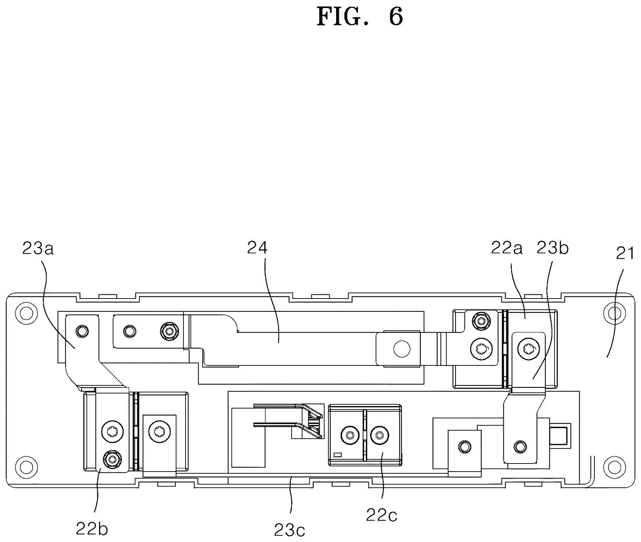

FIG. 5 is an exploded perspective view schematically illustrating an example of a control unit according to another embodiment, and FIG. 6 is a plan view schematically illustrating an example of the control unit of FIG. 5.

Referring to FIGS. 5 and 6, a control unit 20 according to another embodiment may include a body portion 21 in which electronic components may be accommodated, a plurality of relays 22 accommodated in the body portion 21, and a blocking element 24 and connection portions 23 electrically connected to at least one of the plurality of relays 22, and may further include an intermediate cover 25 arranged on the body portion 21 to cover the body portion 21, a top cover 26 arranged to cover the intermediate cover 25, and a wire harness arranged between the top cover 26 and the intermediate cover 25.

The body portion 21 may have a space defined therein to accommodate a plurality of electronic components.

The plurality of relays 22 may be accommodated in the body portion 21 and may be controlled from an off state to an on state when power is applied from the outside.

The plurality of relays 22 may be mechanical contactors that are turned on or off by a magnetic force of a coil, or semiconductor switches such as MOSFETs.

The plurality of relays 22 may include, for example, a first relay 22a, a second relay 22b, and one or more third relays 22c connected to a first electrode terminal and a second electrode terminal, respectively, as a function of cutting off a power supply from a battery in the case where an issue occurs in a vehicle and a battery system. For example, the first relay 22a may include a main relay connected to a positive terminal, the second relay 22b may include a main relay connected to a negative terminal, and the third relays 22c may include a precharge relay.

In an embodiment, precharge control by the third relay 22c may have a risk of generation of an inrush current in a high voltage capacitor on an inverter input side when a battery load is connected, and thus, to prevent the inrush current from flowing in, a function may be provided to operate the third relay 22c before connecting the first relay 22a and the second relay 22b when the vehicle is started and connect the same to a precharge resistor.

The connection portions 23 may include, for example, a busbar, and may include a positive connection portion 23b, which is electrically connected to the first relay 22a electrically connected to the positive terminal, to form a current path, and negative connection portions 23a and 23c, which are electrically connected to the second relay 22b electrically connected to the negative terminal, to form a current path.

In some embodiments, the blocking element 24 may be arranged on a current path for transmitting, to the first relay 22a, power applied from an external apparatus, e.g., a BMS, and in place of a function of the busbar, the blocking element 24 may transmit, to the first relay 22a, power applied from the BMS.

The positive connection portion 23b may transmit a current flowing as the first relay 22a is controlled to be turned on by the BMS, to an external device, e.g., a positive terminal of the battery, and the negative connection portions 23a and 23c may include, for example, the first of the negative connection portions 23a that transmits, to the second relay 22b, power applied from the external apparatus, e.g., the BMS, and the second of the negative connection portions 23c that transmits, to an external device, e.g., the negative terminal of the battery, the current flowing as the second relay 22b is controlled to be turned on by power applied from the BMS.

The blocking element 24 may be arranged on a current path for transmitting, to the first relay 22a, power applied from the BMS, including the function of the busbar for directly connecting an external connection terminal and the first relay 22a, by using a FPCB, and may include a function of a fuse for blocking an overcurrent and a short-circuit current by an external power supply device when the overcurrent and short-circuit current flow. For example, the blocking element 24 may be arranged between the first relay 22a and the external connection terminal and thus be fractured when an overcurrent and a short-circuit current are applied from the BMS, to block a flow of current flowing to the first relay 22a. By blocking the overcurrent and the short-circuit current flowing to the first relay 12a as described above, the blocking element 24 may protect the electronic components and circuits constituting the control unit 20, and may improve the stability of the battery by preventing the overcurrent and short-circuit current applied to the battery.

In some embodiments, by using the FPCB as the blocking element 24, the cost may be reduced and generation of sparks due to an arc may be prevented.

For example, the FPCB may include a multi-layer FPCB, and may be formed so that respective layers have different patterns, and the respective layers may be electrically connected to one another through via holes formed in the respective layers and thus a plurality of layers may be stacked.

The blocking element 24 may include a plurality of circuit elements, and each of the circuit elements may include a conductive layer, insulating layers located above opposite side surfaces of the conductive layer, and adhesive layers between the conductive layer and the insulating layers.

The conductive layer may include, for example, a copper thin film, and the conductive layer may have a thickness of 0.025 mm to 0.05 mm.

The insulating layer may include, for example, a polymer material, and may include any material that may be used as an insulating layer. For example, the insulating layer may include thermoplastic plastic, more particularly, may include a polymer material having heat resistance at a temperature of 100 °C to 300 °C, and in a selective embodiment, may include polyimide (PI). In some embodiments, in case the insulating layer is fused at less than 100 °C, the insulating layer may be easily fractured even by heat generation due to a normal current and thus a current may be cut off, and in the case where the insulating layer is fused at 300 °C or more, the insulating layer may not be fractured quickly in an overcurrent situation and thus the flow of overcurrent may not be prevented.

The adhesive layer may be arranged between the conductive layer and the insulating layer to prevent a gap between the conductive layer and the insulating layer.

In some embodiments, the blocking element 24 may include, for example, a structure in which a plurality of circuit elements are stacked in a plurality of layers. For example, the circuit elements may be stacked in a plurality of layers as the outermost arranged insulating layers are in contact with each other. In some embodiments, the circuit elements constituting respective layers may be formed to have different patterns, and the respective circuit elements may be formed so that the conductive layers are connected to one another through via holes located in the insulating layers and the adhesive layers, and thus, the circuit elements constituting the respective layers may be electrically connected to one another.

The plurality of circuit elements may be connected to each other in parallel, e.g., may be respectively connected to an external connection device and the first relay 22a in parallel between the external connection device and the first relay 22a.

In an embodiment, each of the plurality of circuit elements may be stacked in a plurality of layers. In some embodiments, the circuit elements stacked in a plurality of layers may be stacked in a height direction of the control unit 20, i.e., in a thickness direction of the blocking element 24. In some embodiments, the plurality of circuit elements stacked as described above may be respectively connected to the external connection device and the first relay 22a in parallel between the external connection device and the first relay 22a to have a parallel structure.

As described above, the plurality of circuit elements may be respectively connected to the external connection device and the first relay 22a in parallel between the external connection device and the first relay 22a to have the parallel structure, and thus, the blocking element 24 may block the flow of current only when all circuit elements constituting the blocking element 24 are fractured. In contrast, damage to layers of one circuit element or a plurality of circuit elements may not block the flow of current, and thus, the blocking element 24 may perform the function of the busbar even in the case where a defect occurs in layers of one circuit element or a plurality of circuit elements.

The circuit elements stacked in a plurality of layers may be fractured starting from the circuit element located at a central portion when a temperature rises due to a flow of an overcurrent. To this end, the conductive layer of the circuit element located at the central portion may be formed greater than (e.g., larger than) the conductive layers of the circuit elements at the other layers to allow a large amount of current to flow starting from the central portion.

In some embodiments, the circuit elements may be stacked in 14 layers to 38 layers, and in this case, the conductive layer may have a thickness 0.025 mm to 0.05 mm. As described above, the circuit elements may be stacked in 14 layers to 38 layers, and the conductive layer may have a thickness of 0.025 mm to 0.05 mm, and thus, all the conductive layers constituting the blocking element 24 may implement an optimal volume. In some embodiments, the conductive layer may have a total volume of 2025 mm³ to 2475 mm³.

In some embodiments, in the case where the circuit elements are stacked in fewer than 14 layers, the thickness of the blocking element 24 may excessively decrease and may be fractured by external impact, rather than by an overcurrent, and in the case where the circuit elements are stacked in 38 layers or more, the thickness of the blocking element 24 may excessively increase and thus take up a lot of internal space inside the control unit 20.

In some embodiments, the thickness of the conductive layer may vary according to the number of stacks of the circuit elements, in the case where the circuit elements are stacked in 14 layers to 38 layers, the thickness of the conductive layer may have a thickness of 0.025 mm to 0.05 mm, and in the case where the thickness of the conductive layer is less than 0.025 mm, the total volume of the conductive layer applied to the blocking element 24 may decrease, and thus, a weaker current than a current at a desired level may flow, and in the case where the thickness of the conductive layer exceeds 0.05 mm, the total volume of the conductive layer applied to the blocking element 24 may excessively increase, and thus, the blocking element 24 may not be fractured by a fusing current.

In some embodiments, in the case where the total volume of the conductive layer is less than 2025mm³, a normal current, i.e., a weaker current than a current at a desired level may flow, and in the case where the total volume of the conductive layers exceeds 2475 mm³, the blocking element 24 may not be fractured by the fusing current. In some embodiments, the normal current may be a current of about 200 A, and the fusing current may be a current of about 3200 A flowing for a short period of time.

In a selective embodiment, the control unit 20 may block a high voltage and a high current greater than a normal voltage and a normal current applied in normal times by changing a stack structure of the circuit element according to the capacity of a current being applied. For example, in the case where the capacity of a current being applied in normal times is greater, the total volume of the conductive layer applied to the blocking element 24 may increase by increasing layers of the circuit element being stacked, and in the case where the capacity of the current being applied in normal times is smaller, the total volume of the conductive layer applied to the blocking element 24 may decrease by decreasing layers of the circuit element being stacked. As described above, an action may be easily taken according to the capacity of a current being applied by changing the stack structure of the circuit element according to the capacity of the current being applied and accordingly, a high voltage and a high current applied by an overcurrent may be easily blocked.

As a result, by replacing a fuse with a FPCB, the control unit 20 according to an embodiment may reduce the cost by replacing a high-priced fuse material and may stably block an overcurrent when the overcurrent flows.

A battery pack according to an embodiment may include at least one battery module and a pack housing having an accommodation space for accommodating the at least one battery module.

The battery module may include a plurality of battery cells and a module housing. The battery cells may be accommodated inside the module housing in a stacked form. The battery cell may include a positive lead and a negative lead. The battery cell may include a circular type, prismatic type, or pouch type battery cell according to a type of a battery.

The battery pack may include one module formed by one cell stack instead of the battery module. The cell stack may be accommodated in the accommodation space of the pack housing, or may be accommodated in an accommodation space partitioned by a frame, a partition wall, or the like.

The battery cell may generate a large amount of heat during charging/discharging. The generated heat may be accumulated in the battery cell and thus accelerate the deterioration of the battery cell. Therefore, the battery pack may further include a cooling element to suppress the deterioration of the battery cell. The cooling element may be provided at a lower portion of the accommodation space accommodating the battery cell, but is not limited thereto, and may be provided at an upper portion or on a side surface according to the battery pack.

Each of the battery cells may discharge an exhaust gas inside the battery cell, which is generated in an abnormal operating condition that is also known as thermal runaway or a thermal event, to the outside of the battery cell. The battery pack or the battery module may include an exhaust port or the like for the discharge of the exhaust gas to inhibit the battery pack or the battery module from being damaged by the exhaust gas.

The battery pack may include a battery and a BMS for managing the battery. The BMS may include a detection unit, a balancing unit, and a control unit. The battery module may include a plurality of cells connected to one another in series or in parallel. The battery modules may be connected to each other in series or in parallel.

The detection unit may detect state information indicating a state of the battery by detecting the state (e.g., a voltage, a current, a temperature, or the like) of the battery. The detection unit may detect a voltage of each cell or each battery module constituting the battery. The detection unit may also detect a current flowing in the battery module or each battery module constituting the battery pack. The detection unit may detect a cell and/or a module and/or an ambient temperature at at least one point in the battery.

The balancing unit may perform a balancing operation of a battery module and/or cells constituting the battery. The control unit may receive the state information (e.g., the voltage, the current, the temperature, or the like) of the battery module from the detection unit. The control unit may monitor and calculate the state (e.g., the voltage, the current, the temperature, a state of charge (SOC), a state of health (SOH), or the like) of the battery module on the basis of the state information received from the detection unit. In some embodiments, the control unit may also perform a control function (e.g., temperature control, balancing control, charge/discharge control, or the like), a protection function (e.g., overdischarge, overcharge, overcurrent prevention, short circuit, fire extinguishing, or the like) on the basis of the result of monitoring the state. In an embodiment, the control unit may also perform a wired or wireless communication function with an external device of the battery pack (e.g., a higher controller, a vehicle, a charger, a PCS, or the like).

The control unit may also control charging/discharging operations and a protection operation of the battery. To this end, the control unit may include a charging/discharging controller, a balancing controller, and a protector.

The BMS may refer to a system that monitors a state of a battery, and performs diagnosis and control, communication, and protection functions, and may calculate a charging/discharging state, calculate a SOH of a battery, cut off power of the battery (control a relay), control thermal management (cooling, heating, or the like), perform a high voltage interlock function, and detect or calculate an isolation and short-circuit state.

In some embodiments, a control unit according to an embodiment may include a body portion in which electronic components may be accommodated, a plurality of relays accommodated in the body portion, and a blocking element and connection portions electrically connected to at least one of the plurality of relays, and may further include an intermediate cover arranged on the body portion to cover the body portion, a top cover arranged to cover the intermediate cover, and a wire harness arranged between the top cover and the intermediate cover.

The body portion may have a space defined therein to accommodate a plurality of electronic components.

The plurality of relays may be accommodated in the body portion to be controlled from an off state to an on state when power is applied from the outside.

The plurality of relays may include, for example, a first relay, a second relay, and one or more third relays connected to a first electrode terminal and a second electrode terminal, respectively, as a function of cutting off a power supply from the battery in the case where an issue occurs in a vehicle and a battery system. For example, the first relay may include a main relay connected to a positive terminal, the second relay may include a main relay connected to a negative terminal, and the third relays may include a precharge relay.

The connection portions may include, for example, a busbar, and may include a positive connection portion, which is electrically connected to the first relay electrically connected to the positive terminal, to form a current path and a negative connection portion, which is electrically connected to the second relay electrically connected to the negative terminal, to form a current path.

The blocking element may include a function of the busbar that is arranged on a current path for transmitting, to the first relay, power applied from the BMS and directly connects an external connection terminal and the first relay by using a FPCB, and may include a function of a fuse for cutting off an overcurrent and a short-circuit current when the overcurrent and the short-circuit flow by an external power supply unit. For example, the blocking element may be arranged between the first relay and the external connection terminal and thus be fractured when an overcurrent and a short-circuit current are applied from the BMS, to block a flow of a current flowing to the first relay. By blocking the overcurrent and the short-circuit current flowing to the first relay 12a as described above, the blocking element may protect electronic components and circuits constituting the control unit, and may improve the stability of the battery by preventing the overcurrent and the short-circuit current applied to the battery.

In some embodiments, by using the FPCB as the blocking element, the cost may be reduced and generation of sparks due to an arc may be prevented.

For example, the FPCB may include a multi-layer FPCB, and may be formed so that respective layers have different patterns, and the respective layers may be electrically connected to one another through via holes formed in the respective layers and thus a plurality of layers may be stacked.

The blocking element may include a plurality of circuit elements, and each of the circuit elements may include a conductive layer, insulating layers located above opposite side surfaces of the conductive layer, and adhesive layers between the conductive layer and the insulating layers.

In some embodiments, the blocking element may include, for example, a structure in which a plurality of circuit elements are stacked in a plurality of layers. For example, the circuit elements may be stacked in a plurality of layers as the outermost arranged insulating layers are in contact with each other. In some embodiments, the circuit elements constituting respective layers may be formed to have different patterns, and the respective circuit elements may be formed so that the conductive layers are connected to one another through via holes located in the insulating layers and the adhesive layers, and thus, the circuit elements constituting the respective layers may be electrically connected to one another.

The plurality of circuit elements may be connected to one another in parallel, e.g., may be respectively connected to an external connection device and the first relay in parallel between the external connection device and the first relay.

In an embodiment, each of the plurality of circuit elements may be stacked in a plurality of layers. In some embodiments, the circuit elements stacked in a plurality of layers may be stacked in a height direction of the control unit, i.e., in a thickness direction of the blocking element. In some embodiments, the plurality of circuit elements stacked as described above may be respectively connected to the external connection device and the first relay in parallel between the external connection device and the first relay to have a parallel structure.

As described above, the plurality of circuit elements may be respectively connected to the external connection device and the first relay in parallel between the external connection device and the first relay to have the parallel structure, and thus, the blocking element may block a flow of a current only when all circuit elements constituting the blocking element are fractured, and in contrast, damage to layers of one circuit element or a plurality of circuit elements may not block the flow of the current, and thus, the blocking element may perform the function of the busbar even in the case where a defect occurs in layers of any one circuit element or a plurality of circuit elements.

The circuit elements stacked in a plurality of layers may be fractured starting from the circuit element located at a central portion when a temperature rises due to a flow of an overcurrent. To this end, the conductive layer of the circuit element located at the central portion may be formed greater than the conductive layers of the circuit elements at the other layers to allow a large amount of current to flow starting from the central portion.

In some embodiments, the circuit elements stacked in a plurality of layers may be fractured starting from the circuit element located at the central portion when the temperature rises due to the flow of the overcurrent. To this end, the conductive layer of the circuit element located at the central portion may be formed greater than the conductive layers of the circuit elements at the other layers to allow a large amount of current to flow starting from the central portion.

In some embodiments, the circuit elements may be stacked in 14 layers to 38 layers, and in this case, the conductive layer may have a thickness 0.025 mm to 0.05 mm. As described above, the circuit elements may be stacked in 14 layers to 38 layers, and the conductive layer may have a thickness of 0.025 mm to 0.05 mm, and thus, all the conductive layers constituting the blocking element may implement an optimal volume. In some embodiments, the conductive layer may have the total volume of 2025 mm³ to 2475 mm³.

In some embodiments, in the case where the circuit elements are stacked in fewer than 14 layers, the thickness of the blocking element may excessively decrease and may be fractured by external impact, rather than by an overcurrent, and in the case where the circuit elements are stacked in 38 layers or more, the thickness of the blocking element may excessively increase and take up a lot of internal space inside the control unit.

In some embodiments, the thickness of the conductive layer may vary according to the number of stacks of the circuit elements, in the case where the circuit elements are stacked in 14 layers to 38 layers, the conductive layer may have the thickness of 0.025 mm to 0.05 mm, and in the case where the thickness of the conductive layer is less than 0.025 mm, the total volume of the conductive layer applied to the blocking element may decrease, and thus, a weaker current than a current at a desired level may flow, and in the case where the thickness of the conductive layer exceeds 0.05 mm, the total volume of the conductive layer applied to the blocking element may excessively increase, and thus, the blocking element may not be fractured by a fusing current.

In some embodiments, in the case where the total volume of the conductive layer is less than 2025 mm³, a normal current, i.e., a weaker current than a current at a desired level may flow, and in the case where the total volume of the conductive layers exceeds 2475 mm³, the blocking element may not be fractured by the fusing current. In some embodiments, the normal current may be a current of about 200 A, and the fusing current may be a current of about 3200 A flowing for a short period of time.

In battery packs that accommodate large-capacity secondary batteries described above, overcurrents and short-circuit currents that may be generated during use of the battery packs may deteriorate the stability of the battery packs, and thus, a method capable of stably controlling an overcurrent and a short-circuit current is needed.

In an embodiment, the control unit may block a high voltage and a high current greater than a normal voltage and a normal current applied in normal times by changing a stack structure of the circuit element according to the capacity of a current being applied. For example, in the case where the capacity of a current being applied in normal times is greater, the total volume of the conductive layer applied to the blocking element may increase by increasing layers of the circuit element being stacked, and in the case where the capacity of the current being applied in normal times is smaller, the total volume of the conductive layer applied to the blocking element may decrease by decreasing layers of the circuit element being stacked. As described above, an action may be easily taken according to the capacity of a current being applied by changing the stack structure of the circuit element according to the capacity of the current being applied and accordingly, a high voltage and a high current applied by an overcurrent may be easily blocked.

By way of summary and review, the present disclosure replaces a fuse in a control unit to block an overcurrent or short-circuit current with a flexible circuit board having a plurality of (e.g., multi-layered) circuit elements. As a result, according to embodiments, a battery pack may have improved stability and economic feasibility by including a control unit including a FPCB.

Although the disclosure has been described above with reference to limited embodiments and drawings, the disclosure is not limited thereto, and various modifications and changes may be made by those skilled in the art within the disclosure and the equivalent range of claims described below.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A control unit, comprising:
a body portion (11; 21);
a plurality of relays (12; 22) accommodated in the body portion (11; 21); and
a blocking element (15; 24) electrically connected to at least one relay from among the plurality of relays (12; 22), the blocking element (15; 24) blocking a flow of an overcurrent, wherein the blocking element (15; 24) comprises a flexible printed circuit board.

2. The control unit as claimed in claim 1, wherein the flexible printed circuit board comprises:
a plurality of circuit elements (140) connected to one another in parallel, and
the plurality of circuit elements (140) are fractured when a temperature increases due to the overcurrent.

3. The control unit as claimed in claim 2, wherein each of the plurality of circuit elements (140) comprises:
a conductive layer (143);
insulating layers (141) above opposite side surfaces of the conductive layer (143); and
adhesive layers (142) between the conductive layer (143) and the insulating layers (141).

4. The control unit as claimed in claim 3, wherein the conductive layer (143) comprises a copper thin film.

5. The control unit as claimed in claim 3 or claim 4, wherein the conductive layer (143) has a thickness of 0.025 mm to 0.05 mm.

6. The control unit as claimed in any one of claims 2 to 5, wherein, when the temperature increases, the plurality of circuit elements (140) are fractured starting from a circuit element of the plurality of circuit elements (140) at a central portion.

7. The control unit as claimed in any one of claims 2 to 6, wherein the plurality of circuit elements (140) are stacked in a height direction of the control unit.

8. The control unit as claimed in claim 7, wherein the plurality of circuit elements (140) are stacked in 14 layers to 38 layers in the height direction of the control unit.

9. The control unit as claimed any one of claims 1 to 8, wherein:
the plurality of relays (12; 22) comprise a first relay (12a; 22a) and a second relay (12b; 22b),
the first relay (12a; 22a) is on a current path electrically connected to a first electrode, and
the second relay (12b; 22b) is on a current path electrically connected to a second electrode.

10. The control unit as claimed in claim 9, wherein:
the first relay (12a; 22a) is on a current path electrically connected to a positive electrode, and
the blocking element (15; 24) is electrically connected to the first relay (12a; 22a).

11. The control unit as claimed in any one of claims 1 to 10, further comprising a battery management system, wherein, when power is applied from the battery management system, the plurality of relays (140) are controlled from an off state to an on state.

12. A battery pack, comprising:
a housing accommodating at least one battery; and
a battery management system configured to manage the at least one battery, wherein the battery management system comprises a control unit as claimed in any one of claims 1 to 10.

13. The battery pack as claimed in claim 12, wherein, when power is applied from the battery management system, the plurality of relays (140) are controlled from an off state to an on state.
